Europäisches Patentamt

European Patent Office

Office européen des brevets

(11) Publication number: **0 138 547 B1**

(12) **EUROPEAN PATENT SPECIFICATION**

(45) Date of publication of patent specification: **22.01.92**  (51) Int. Cl.⁵: **H04B 1/62**, H03G 5/16

(21) Application number: **84306848.7**

(22) Date of filing: **08.10.84**

(54) Spectral emphasis and de-emphasis circuits.

(30) Priority: **07.10.83 US 540195**
**07.10.83 US 540421**
**21.08.84 US 642044**

(43) Date of publication of application:
**24.04.85 Bulletin 85/17**

(45) Publication of the grant of the patent:
**22.01.92 Bulletin 92/04**

(84) Designated Contracting States:
**AT BE CH DE FR GB IT LI NL SE**

(56) References cited:
US-A- 3 678 416
US-A- 4 101 849

JOURNAL OF THE AUDIO ENGINEERING SO-
CIETY, vol. 32, no. 9, September 1984, pages
659-672, New York, US; R.W. ADAMS:
"Companded predictive delta modulation: a
low-cost conversion technique for digital re-
cording"

THE BELL SYSTEM TECHNICAL JOURNAL,
vol. 60, no. 5, May-June 1981, pages 719-739,
American Telephone and Telegraph Co.,
Murray Hill, New Jersey, US; J.O. SMITH et
al.: "Variable bandwidth adaptive delta mod-

ulation"

TELEVISION: JOURNAL OF THE ROYAL TELE-
VISION SOCIETY, vol. 21, no. 4, July/August
1984, pages 145-147, London, GB; D. WATTS:
"A digital audio system for satellite cable
and broadcasting"

(73) Proprietor: **DOLBY LABORATORIES LICENS-
ING CORPORATION**
**100 Potrero Avenue**
**San Francisco California 94103-4813(US)**

(72) Inventor: **Gundry, Kenneth James**
**1236 Washington Street**
**San Francisco California 94109(US)**
Inventor: **Todd, Craig C.**
**Star Route, Box 458**
**Muir Beach California 94965(US)**

(74) Representative: **Pears, David Ashley et al**
**REDDIE & GROSE 16 Theobalds Road**
**London WC1X 8PL(GB)**

**Description**

This invention relates to a spectral emphasis circuit comprising a spectral analysis circuit providing a control signal indicative of the predominant frequency region of an input information signal, and an adaptive circuit controlled by the control signal to impose a variable emphasis or de-emphasis characteristic on the input information signal. The invention further relates to a spectral de-emphasis circuit for use with the emphasis circuit.

A spectral emphasis circuit of the indicated above is known fro US-A-4,101,849, where the circuit is used in conjunction with a high-frequency compressor or expander to reduce noise modulation effects. A control signal is derived in dependence on the relative levels of signals passed by feed high and low frequency filters. Depending on the control signal, the so-called pre-emphasis circuit precedes a wide-band logarithmic analog compressor and actually applies a boost or cut (de-emphasis) to the low frequency region in conjunction with the high frequency compression, depending on whether the dominant signal is in the high or low frequency region. A complementary circuit follows the expander.

Such characteristics are unsuited to other applications of emphasis and de-emphasis. The present invention is concerned in particular with problems which arise when an audio or other signal is subjected to analogue to digital (A-D) conversion before transmission and then subjected to digital to analogue (D-A) conversion after transmission.

In many adaptive A-D and D-A coding systems the step-size used increases with the level of the input signal. Since quantizing noise increases with the step-size the quantizing noise of such adaptive systems increases with the input signal level, an example of the effect known as noise modulation. The effects of noise modulation is disturbing in many applications, such as in high quality audio.

It is a characteristic of human hearing that spurious spectral information is much less audible if it is close in frequency to the desired audio signal. If the spurious energy lies far from the desired audio signal frequency it is much more likely to be audible. Thus where the noise level is a function of the input signal level it is particularly important to reduce noise whose frequencies are far from the desired audio signal.

Conventional noise reduction systems have been used to apply adaptive emphasis and de-emphasis to reduce audible noise. One conventional system employs fixed emphasis for boosting high frequency signals and complementary de-emphasis for bucking such signals. When such emphasis and de-emphasis are used to reduce audible noise that increases with signal level and when the predominant signals are of high frequencies, low frequency noise will instead be increased. Fixed high frequency emphasis and de-emphasis are therefore unsatisfactory for reducing such noise.

A well known type of circuit, called "sliding band", reduces audible high frequency noise by way of a filter with a variable corner frequency. As the level of high frequency signals increases, the filter corner frequency slides upwardly to narrow the band boosted and cut. Examples of such circuits are to be found in US-PS Re 28,426, US-PS 4,072,914 and US-PS 3,934,190.

The sliding of the filter corner frequency depends on both the amplitude and frequency of the input signal. If such a "sliding band" type circuit is used to reduce audible noise that is a function of input signal level, low frequency noise may also be increased when the predominant spectral components of the input signal are at very high frequencies. While such a problem is not as serious as in the case of the high frequency fixed emphasis and de-emphasis, the "sliding band" type circuit is not entirely satisfactory for reducing noise which increases with signal level.

US-A-3,678 416 discloses a dynamic noise filter with variable high pass and low pass filters which are used to leave only a middle frequency region unfiltered, the cut-off points of the filters being controlled by control signals with fast attack and slow decay. This reference also discloses a click suppressor which switches paths, with a suitable delay, when a click is detected in order to pass the signal via a sample and hold circuit and cut out the click.

In contrast to such prior art the present invention is concerned with the type of circuit defined in the first paragraph above where there is a control signal which is dependent essentially upon the spectral content of the input signal, not upon the amplitude of spectral components.

The problem underlying the invention in a first aspect is that of allowing the control signal to be handled in a non-critical way. This leads to several possibilities for saving in circuit complexity and expense, as will be explained below.

The spectral emphasis circuit according to a first aspect of the invention is characterized in that the control signal is bandwidth limited so as to change slowly relative to the input signal, and by a first delay circuit delaying the input signal to the adaptive circuit to compensate for the slow response of the control signal.

The use of a delay circuit to compensate for the delay of a control signal smoothing circuit is known per

2

se in other contexts. US 4,169,219 suggests this in relation to the control signal for a variable gain compressor or expander circuit. The present invention resides more in the appreciation that suitably severe bandwidth limitation can render the control signal non-critical. Some mismatch between the timings of control signals in complementary emphasis and de-emphasis circuits can be tolerated. The control signal can be transmitted so that the spectral analysis circuit is needed only in the emphasis circuit. The received control signal is subject to error (e.g. bit errors if also transmitted digitally) but will nevertheless control the de-emphasis circuit satisfactorily because it is bandwidth limited therein. Moreover, as will be shown below, the de-emphasis circuit can be further simplified by effectively placing all delay circuits in the emphasis circuit.

The invention makes use of the observation that in order to reduce noise whose level is a function of the input signal level, the different spectral components of the input signal may be altered depending on the spectral composition of the input signal by subjecting the input signal to emphasis and subsequent de-emphasis in a complementary manner to recover an output signal which is substantially similar to the input signal. The spectral emphasis and de-emphasis circuits of this invention are particularly advantageous for reducing audible quantizing noise in many adaptive A-D and D-A coding systems.

The spectral emphasis circuit may further comprise means for transmitting the information signal subjected to emphasis and means for also transmitting the control signal, the information signal being transmitted with a delay relative to the control signal corresponding to the delay provided by the first delay circuit.

The de-emphasis circuit can then receive the transmitted information and control signals and comprises an adaptive circuit imposing on the received information signal a variable de-emphasis characteristic complementary to the variable emphasis characteristic imposed in the emnphasis circuit, the adaptive circuit being controlled by the received control signal.

The invention further provides a spectral de-emphasis circuit according to claim 9 and a complementary emphasis/de-emphasis method as defined in claim 17.

Another aspect of the invention is directed to a particular emphasis and complementary de-emphasis which when applied to a medium whose noise level is a function of the signal level in the medium, reduces noise introduced by the medium. In such aspect, the spectral emphasis circuit of the invention is characterized in that when the predominant signal components are concentrated in a first frequency range, the variable characteristic consists of a sliding high-frequency boost with its corner frequency sliding upwards in response to the control signal to stay above the frequencies of the predominant signal components leaving the predominant signal components substantially unchanged, whereas when the predominant bit signal components are concentrated in a second frequency range with frequencies above those of the first frequency range, the variable characteristic of the emphasis consists of sliding high-frequency boost with its corner frequency above those of the predominant bit signal components but a cut at the frequencies of the predominant signal components themselves.

The restoring or spectral de-emphasis circuit is characterized by an adaptive circuit controlled by the control signal to impose a variable de-emphasis characteristic on the input information signal, so that when the predominant signal components are concentrated in a first frequency range, the variable de-emphasis characteristic consists of a sliding high-frequency cut with its corner frequency sliding upwards in response to the control signal to stay above the frequencies of the predominant signal components leaving the predominant signal components substantially unchanged, whereas when the predominant signal components are concentrated in a second frequency range with frequencies above those of the first frequency range, the variable de-emphasis characteristic consists of sliding high-frequency cut with its corner frequency above those of the predominant signal components but a boost at the frequencies of the predominant signal components themselves.

Such circuits are particularly advantageous for reducing noise which increases with signal level as well as signal frequency.

The invention will be described by way of example, with reference to the accompanying drawings, in which:-

Fig. 1 is a graphical illustration of the noise distortion emerging from an adaptive delta modulation coder-decoder as a function of the step-size applied by the coder-decoder.

Fig. 2A is a block diagram of an encoder which includes a pre-processing circuit illustrating an embodiment of this invention.

Fig. 2B. is a block diagram of a decoder which includes a post-processing circuit illustrating the preferred embodiment of this invention.

Figs. 3A and 3B are graphical illustrations of respectively the pre-emphasis characteristics of the pre-processing circuit of Fig. 2A and the de-emphasis characteristics of the post-processing circuit of Fig.

2B.

Fig.4 is a block diagram illustrating the preferred embodiment for a portion of the pre-processing circuit of Fig.2A.

Fig. 5 is a block diagram of a decoder which includes a post-processing circuit, the diagram containing the system definition of the decoder to illustrate the preferred embodiment of the invention.

Fig. 6 is a schematic circuit diagram for the circuit of Fig. 5 to illustrate the invention.

Detailed Description Of The Preferred Embodiment

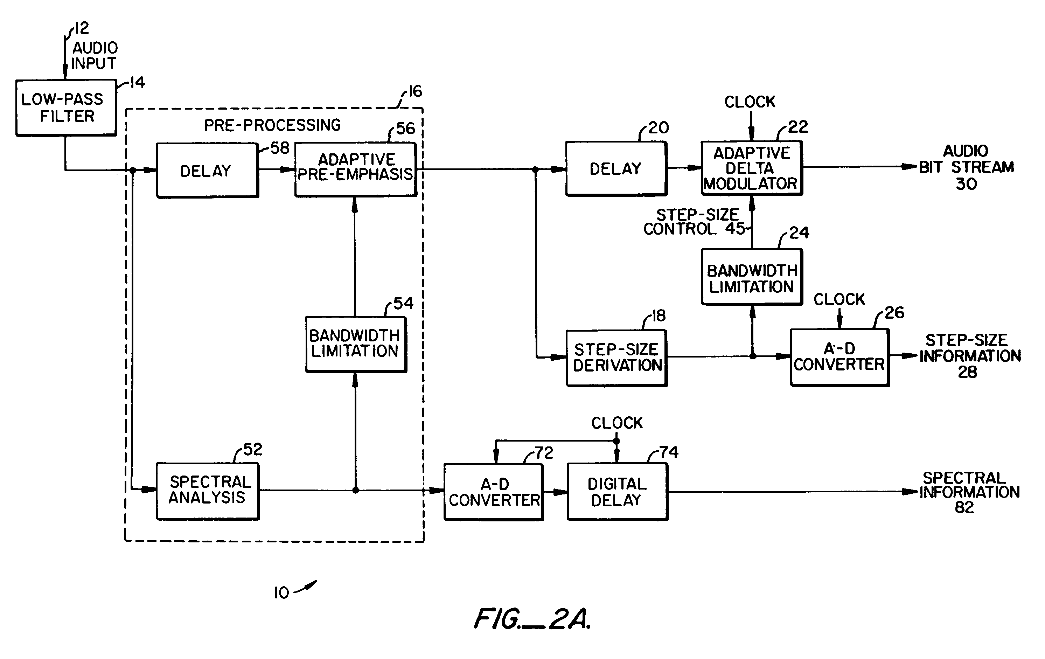

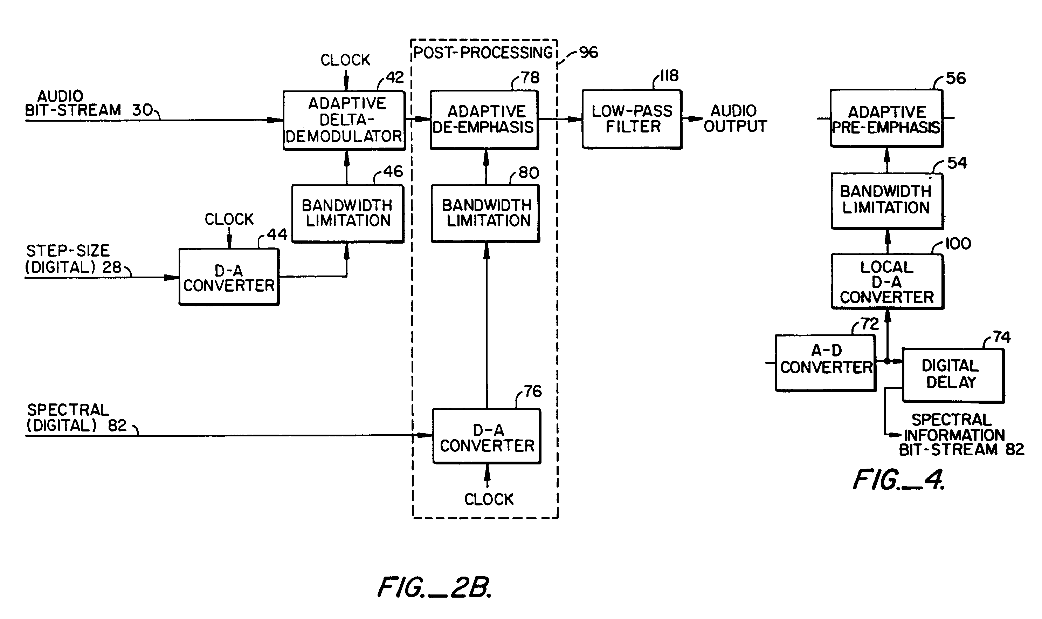

The spectral composition altering and restoration circuits of this invention are particularly suitable for reducing noise which is a function of signal level. Below is a description of an A-D and D-A conversion system whose noise level rises with the signal level; the description will serve as a background desirable for understanding this invention. Figs. 2A and 2B are block diagrams for an adaptive A-D encoder and D-A decoder system which includes a pre-processing circuit and a post-processing circuit for altering and restoring the spectral composition of signals to illustrate this invention. The derivation, transmission and processing of step-size information in the encoder-decoder system is the subject of the companion application No. 8430649.5, now EP-A-0 138 548 (see also divisional applications 90200454.8 and 90200455.5, now EP-A-0 376 933 and 0 384 544). The discussion that immediately follows concerning step-size determination is taken from such companion application.

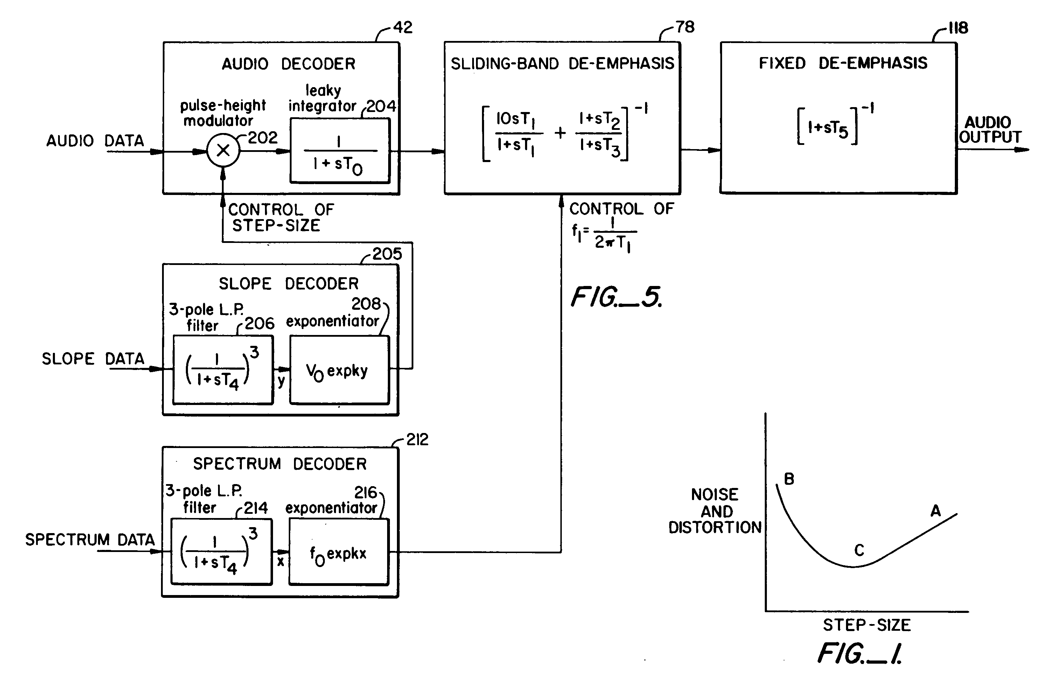

The noise and distortion emerging from an ADM encoder-decoder system (codec) depend on the audio input signal and the step-size, both of which are varying. Consider a codec handling a single sine wave. As a function of step-size, the output noise and distortion will vary as shown qualitatively in Fig. 1. In the region labelled A, the step-size is too large, which produces excessive quantizing noise. In region B the step-size is too small and the system is in overload which produces high noise and distortion. There is an optimum value of step-size for the particular input condition labelled C. For each short time segment of real audio there is a curve like that of Fig. 1, and an optimum step-size. In a conventional output controlled ADM system the step-size rarely achieves the optimum value, but remains in region A most of the time, moving into region B on signal transients. The object of this invention is to design an ADM system that operates as much as possible in region C, and that operates so that the delta modulator is fully loaded. This is possible because the step-size determination is done in the encoder and is input controlled as explained below.

Fig. 2A is a block diagram for an encoder illustrating an embodiment of this invention. As shown in Fig. 2A, an analog audio input signal 12 is passed through a low-pass filter 14 to determine the overall audio bandwidth of the analog input signal. Typically such bandwidth may be 15 kHz. The analog input signal is then passed through a pre-processing circuit 16. The function of the pre-processing circuit 16 will be discussed below.

After being pre-processed the analog audio input signal is supplied to a step-size derivation circuit 18 and to a delay circuit 20. In one particular application the step-size derivation circuit 18 comprises a slope detector for detecting the time derivative or slope of the incoming audio input signal. The slope detector then generates a control signal indicative of the step-size to be used in the adaptive delta modulator 22. The control signal is limited by a bandwidth limitation circuit 24 and then applied to the adaptive delta modulator 22. A-D converter 26 converts the step-size control signal into a bit-stream of digital signals to convey step-size information. After being time delayed by delay circuit 20 the audio input signal is converted into a bit-stream of digital audio signals by adaptive delta modulator 22 in accordance with the step-size indicated by the bandwidth limited step-size control signal 45. The audio bit-stream and the step-size information bit-stream are then transmitted through a medium to a decoder which is shown in Fig. 2B. In one particular application encoder 10 is part of a broadcasting station transmitting the audio and step-size information bit-streams to decoders in consumer systems. The function of delay circuit 20 and bandwidth limitation circuit 24 will be discussed after a brief description of the decoder of Fig. 2B below.

Fig. 2B is a block diagram of a decoder illustrating the preferred embodiment of this invention. As shown in Fig. 2B decoder 40 comprises an adaptive delta demodulator 42 for receiving the digital audio bit-stream 30 transmitted through the medium and a D-A converter 44 for receiving the digital step-size information bit-stream 28. D-A converter 44 converts the digital bit-stream into an analog step-size control signal which is supplied to bandwidth limitation circuit 46. After being limited in bandwidth, the step-size control signal is applied to adaptive delta demodulator 42. Adaptive delta demodulator 42 generates an analog audio output signal from the audio bit-stream in accordance with bandwidth limited step-size control signal from bandwidth limitation 46. Bandwidth limitation circuit 24 of Fig. 2A limits the bandwidth of the step-size control signal applied to adaptive delta-modulator 22 so that the step-size cannot change abruptly from one sample to the next. Similarly, bandwidth limitation circuit 46 limits the bandwidth of the step-size control signal applied to adaptive delta-demodulator 42. Thus if the transmission medium introduces a bit error in the step-size information bit-stream, such an error, after being converted into analog form by D-A converter 44, cannot introduce a major error in the step-size at adaptive delta demodulator 42. The effect of transmission errors is thereby reduced. Therefore, cheap non-precision components may be used to construct the converters 26, 44 and the transmission of the step-size information bit-stream is highly tolerant of bit errors.

The generation of a limited bandwidth step-size control signal will require a finite time. To compensate for such time, delay circuit 20 introduces a time delay so that the pre-processed analog audio input signal will reach adaptive delta modulator 22 at a time when the step-size control signal for such input signal is available from bandwidth limitation circuit 24. This is particularly advantageous when there are sudden changes in the slope of the input audio signal.

While in Figs. 2A and 2B the step-size information bit-stream 28 and audio bit-stream 30 are shown as being transmitted separately, it will be understood that the two bit-streams may be transmitted together in one single channel provided that the two bit-streams can be distinguished from each other. Similarly, all three bit-streams 28, 30 and 82 may also be transmitted in the same channel instead of in separate channels if they can be distinguished from each other.

By introducing a time delay through delay circuit 20 that also compensates for the time delay caused by the bandwidth limitation circuit 46 in the decoder, the audio bit-stream signals which are the digital representation of a particular analog signal reach the delta demodulator when the bandwidth limited step-size control signal is available from circuit 46. In such manner, the need for a delay circuit in the decoder to compensate for the time delay caused by the bandwidth limiting of the step-size control signal in the decoder is eliminated and the decoder circuit is simplified. This is particularly advantageous for lowering the cost of consumer decoder equipment.

The invention of this application will now be discussed. The pre-processing and post-processing circuits 16, 96 and other associated circuit components illustrate this invention. Since the step-size in the A-D and D-A conversions is variable, the noise amplitude will be modulated depending on the step-size and such noise modulation is undesirable in many applications such as in high quality audio equipment. Noise modulation is reduced by pre-processing circuit 16 and post-processing circuit 96 when combined with components A-D converter 72 and digital delay 74 of Fig. 2A. The pre-processing circuit 16 comprises spectral analysis circuit 52, bandwidth limitation circuit 54, adaptive pre-emphasis circuit 56, and delay circuit 58, all of Fig. 2A. The post-processing circuit 96 comprises D-A converter 76, adaptive de-emphasis circuit 78 and bandwidth limitation circuit 80, all of Fig. 2B.

Spectral analysis circuit 52 analyzes the audio input signal to generate an emphasis control signal. The emphasis control signal generated is a function only of the spectrum of the input audio and is substantially independent of the amplitude of the input audio. The emphasis control signal is then limited by bandwidth limitation circuit 54 and applied to adaptive pre-emphasis circuit 56. Adaptive pre-emphasis circuit 56 boosts or boosts and bucks the different frequency components of the input audio signal by amounts which are functions of the emphasis control signal. The emphasis control signal is limited in bandwidth so that the frequency response of the adaptive pre-emphasis circuit 56 will not change suddenly from sample to sample. Bandwidth limitation circuit 80 reduces the effect of bit errors introduced by the transmission medium in a manner similar to bandwidth limitation circuit 46 described above.

In reference to Figs. 2A, 2B, delay circuit 58 introduces a time delay which permits the pre-emphasis circuit 56 to complete its adaptation before the audio input signal is supplied to the pre-emphasis circuit 56. The pre-processed audio input signal is supplied to delay circuit 20 and adaptive delta modulator 22 as described above. The emphasis control signal from spectral analysis circuit 52 is converted into a digital bit-stream carrying spectral information by A-D converter 72 and is delayed by digital delay 74 by a time period substantially equal to that of delay circuit 20.

Comparing the timing relationship of the audio and the spectral information bit-streams, an audio signal in the audio bit-stream has been delayed by delay circuits 58, 20, whereas the corresponding spectral information signal for such audio signal has been delayed by only the digital delay 74. Thus the net effect is that the audio is delayed relative to the corresponding spectral information by the time delay caused by delay 58, so that the spectral information reaches the decoder of Fig. 2B and the post-processing circuit 96 in advance of the corresponding audio signals and at the proper time to change the amplitudes of the various frequency components of the audio signal in a manner complementary to that of the adaptive pre-emphasis circuit 56. The further requirements for complementarity are discussed below. The time delay introduced in the encoder by circuit 58 compensates for the time delay caused by bandwidth limiting the spectral information in bandwidth limitation circuit 80 in the decoder.

If the audio and the corresponding spectral information were synchronous so that they reached the decoder and the post-processing circuit at the same time, the time delay caused by bandwidth limitation circuit 80 would cause the audio to reach the adaptive de-emphasis 78 before the bandwidth limited de-emphasis control signal was available for controlling the de-emphasis. A delay circuit would then be required in the decoder to delay the audio so that the audio would reach the de-emphasis 78 at the appropriate time. By introducing a timing discrepancy between the audio and the corresponding spectral information in the encoder in the manner discussed above, the need for a delay circuit in the decoder equipment is eliminated and the cost of the decoder is reduced.

One of the purposes of the encoder-decoder system of Figs. 2A and 2B is to transmit an analog audio signal through a medium so that the analog audio output signal recovered after the transmission is substantially the same as the input audio. To accomplish this purpose, the adaptive delta modulator 22 in the encoder of Fig. 2A and the adaptive delta demodulator 42 are substantially complementary to each other. In addition, the step-size control signals applied to the modulator 22 and demodulator 42 are substantially the same and are applied to the modulator and demodulator with substantially the same timing relationship with respect to the corresponding audio signals so that the modulation and demodulation applied are complementary. In other words, if the step-size control signal for an audio signal is applied at a time t before or after the audio signal reaches the modulator 22, the step-size control signal should reach the demodulator 42 also at substantially time t before or after the audio signal reaches the demodulator. This assures that the modulation and demodulation applied are substantially complementary. Similarly, the pre-processing and post-processing circuits are also substantially complementary to each other; the emphasis and de-emphasis control signals are substantially the same and have substantially the same timing relationship with respect to the audio for the application of pre-emphasis and de-emphasis so that the pre-emphasis and de-emphasis applied are substantially complementary.

After the above requirements for complementarity are generally met, however, the encoder-decoder system is highly tolerant of timing errors. Since the step-size, pre-emphasis and de-emphasis control signals can only change slowly in the encoder and decoder, the adaptive modulation and demodulation together with the pre-emphasis and de-emphasis applied by the encoder and decoder can only change slowly. Thus mismatch in timing relationship of the type discussed above and of the order of a few percent of the bandwidth limitation rise times will not cause the modulation and demodulation to deviate significantly from being complementary. Similarly mismatch in timing relationship of such order of magnitude will not cause the pre-emphasis and de-emphasis applied to deviate significantly from being complementary.

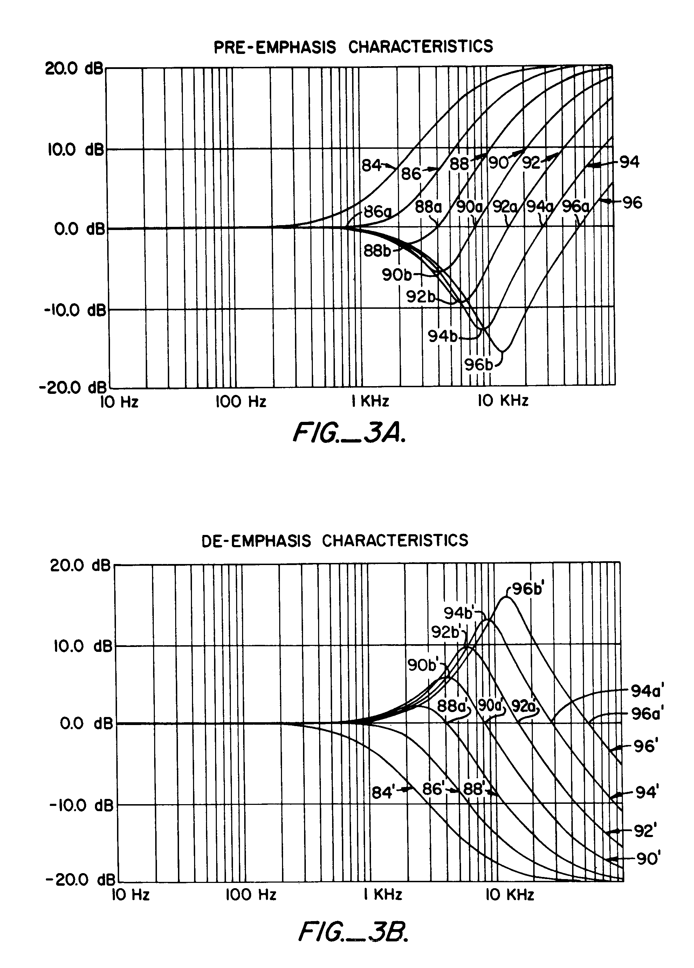

The characteristics of adaptive pre-emphasis and de-emphasis circuits 56, 78 are illustrated in Figs. 3A, 3B. It will be understood that the specific frequencies and gains in Figs. 3A, 3B and in the discussion below are for illustrative purposes only and that the characteristics of circuits 56, 78 are not limited thereby. In some respects, the pre-emphasis and de-emphasis characteristics are similar to the well known type of "sliding band" circuits, which reduce high frequency noise by way of a filter with a variable corner frequency. As the signal level increases, the filter corner frequencies of such "sliding band" circuits slide continuously and upwardly to narrow the band boosted and cut. Examples of such circuits are found in US-PS Re 28,426; US-PS 4,072,914 and US-PS 3,934,190.

The pre-emphasis characteristic of circuit 56 also has a variable frequency indicated at 86a, 88a, 90a, 92a, 94a and 96a of the pre-emphasis characteristic curves 86, 88, 90, 92, 94 and 96 respectively of Fig. 3A. The de-emphasis curves 84'-96' of Fig. 3B are complementary to curves 84-96 respectively and also have variable frequencies 86a'-96a'. Such variable frequencies also continuously shift as a function of the input audio. However, unlike the "sliding band" circuits, the continuous shifting is determined, not by the level of high frequency signals but by the spectral content of the input audio in a manner described below. In the above referenced "sliding band" circuits, the signal components with frequencies higher than the variable corner frequency are boosted (or cut) and those with frequencies lower than the corner frequency remain unchanged. While signals with frequencies higher than the variable frequency are also boosted by circuit 56 as shown in Fig. 3A, for each of curves 90 through 96, there is a spectral region in which signals are bucked. Similarly there is a spectral region for each of de-emphasis curves 90'-96' in which signals are boosted. The detailed characteristics of circuit 56 are described below.

It is assumed first, for the purpose of discussion, that the predominant signal components of the input audio are concentrated in a certain region of the frequency spectrum. When the audio input signal comprises mostly low and middle frequency energy e.g. concentrated in the frequency region below 500 Hz, adaptive pre-emphasis circuit 56 adopts the response labelled 84, boosting only signals with frequencies above 500 Hz; the predominant signals with frequencies below 500 Hz remain substantially unchanged. In other words, there is a high frequency boost with a minimum corner frequency of 500 Hz. This minimum corner frequency could alternatively be 1000 Hz. When the audio signal from the adaptive delta-demodulator 42 reaches adaptive de-emphasis circuit 78 the high frequency components of the quantizing noise will be reduced by adaptive de-emphasis circuit 78 which will have a characteristic 84' complementary to curve 84 as shown in Figs 3A and 3B. High frequency noise above 500 Hz is thereby reduced sufficiently that audible noise modulation becomes much diminished. Low and medium frequency noise below 500 Hz is masked by the signal.

As the frequency of the input audio signal rises so that the predominant signal components are concentrated between about 500 Hz and 2 kHz, the emphasis control signal from the spectral analysis circuit 52 causes the frequency response of adaptive pre-emphasis circuit 56 to slide from 84 to 86 or 88, i.e. the corner frequency slides upwardly. Such dynamic action of the adaptive pre-emphasis circuit prevents undesirable increases in the step-size of the adaptive delta-modulator but still allows the subsequent complementary de-emphasis to reduce noise at frequencies above those of the input signal. Low frequency noise is not yet an audible problem.

The frequency responses of the shape 84, 86, 88 (that is, sliding high frequency boost) are satisfactory for noise reduction when the predominant spectral components of the input audio signal are below 2 or 3 kHz. Noise at frequencies above these predominant spectral components is reduced as described above; lower frequency noise is masked by the signal. When the predominant spectral components of the input audio signal are at high frequencies (e.g.above 3 kHz) such sliding boost responses may no longer be satisfactory for noise reduction, since low and medium frequency noise is no longer masked by the signal. Under these signal conditions the effect of high frequency boost would be to increase the step-size employed in the adaptive delta modulator 22 and demodulator 42, resulting in an increase in wide-band quantizing noise. The subsequent complementary high frequency cut would not reduce the low frequency part of this increased noise. Thus low frequency noise would be modulated by changes in the high frequency components of the input audio signal. Under such conditions, it is desirable to convert the high frequency boost of adaptive pre-emphasis circuit 56 for the spectral region where the predominant signal components of the input audio are concentrated into a cut such as the dips shown as portions 90b, 92b, 94b, 96b of respective curves 90, 92, 94 and 96 in Fig.3A. Therefore, as the frequencies of the predominant spectral components of the input audio signal rise, the frequency response of adaptive emphasis circuit 56 will slide past the curves 84, 86 and 88 to curves 90, 92, 94 and 96.

When the predominant signal components are concentrated in high frequencies such as around 5 kHz, high frequency noise around 5 kHz is masked. Noise at still higher frequencies may not be masked and it may be desirable to reduce such noise while also reducing low frequency noise in the manner described above. Thus the curves 90, 92, 94 and 96 at frequencies above the variable frequency retain the shape of a high frequency shelf. As shown in Fig. 3A, curves 84, 86, 88 tend towards the same fixed gain (eg. 20 dB) at high frequencies. Even though not clearly shown in Fig. 3A, curves 90-96 also tend towards the same fixed gain at still higher frequencies. The complementary de-emphasis curves 84'-96' corresponding to respective pre-emphasis curves 84-96 are shown in Fig. 3B, and have variable frequencies 86a'-96a' which are substantially the same as those of the pre-emphasis curves. De-emphasis curves 90'-96' have peaks 90b'-96b' corresponding to dips 90b-96b of the pre-emphasis curves of Fig. 3A.

The overall effect of the curves 90-96 can now be described. Pre-emphasis curves with dips at the spectral regions of the predominant signal components will reduce the step-size and hence the broad-band noise emerging from the encoder-decoder system. The subsequent de-emphasis peaks 90b', 92b', 94b' and 96b' will pick out the wanted predominant signal components and restore them to their original amplitudes. The de-emphasis will also buck the signals at frequencies above the variable frequencies to reduce very high frequency noise. Thus the reduced low frequency noise level is retained, high frequency noise is masked and very high frequency noise is reduced.

In the above discussion, it has been assumed that the predominant signal components of the input audio are concentrated in a certain region of the frequency spectrum. Such an input signal is in fact the most critical case. When the signal spectral components are more distributed, their masking properties cover more of the noise, and the shapes of the pre-emphasis curves are less critical. If the signal spectral components are distributed in two regions of the frequency spectrum, the pre-emphasis curve will resemble the curve for the case where the spectral components are concentrated in a region between such two regions.

Bandwidth limitation circuits 24,46, 54 and 80 limit the step-size and spectral control signals to within bandwidths of a few tens or low hundreds of Hz; hence the control signals can have rise times of a few milliseconds. The delay introduced by delay circuits 20, 58 is therefore chosen to be substantially equal to the rise times of the control signals as determined by the bandwidth limiting. Suitable values are in the range 5 to 20 milliseconds. The control A-D and D-A converters 26, 44, 72 and 76 may be simple delta or delta-sigma modulators and demodulators operating at a few kilobits per second. In television sound applications a convenient value is half the horizontal frequency, about 7.8 kHz.

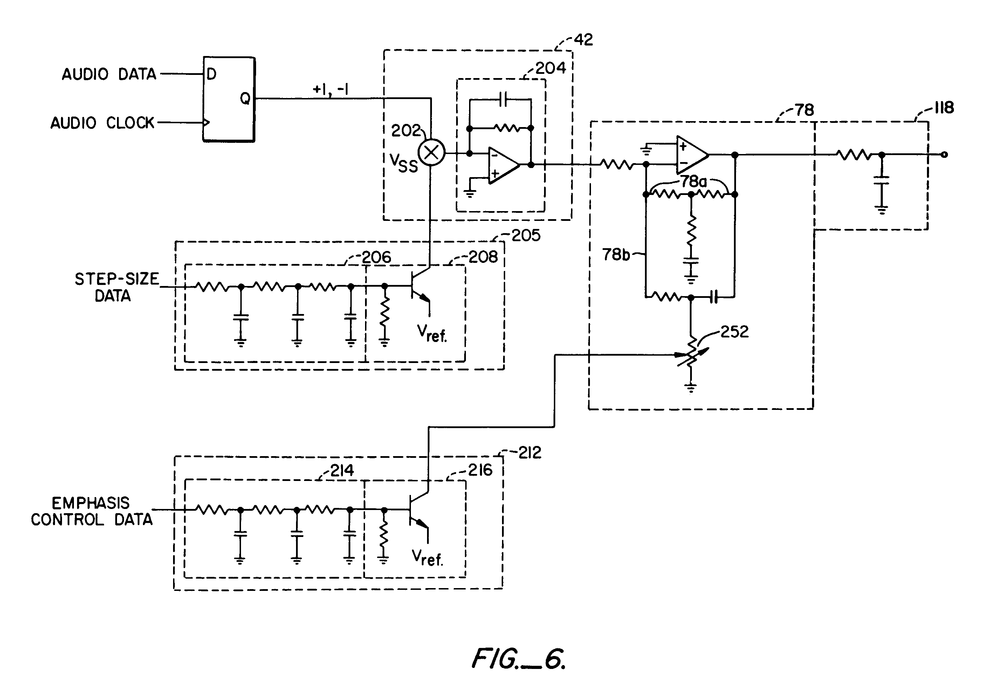

For convenience in instrumentation and better tracking between encoder and decoder, the signal entering bandwidth limitation 54 in the encoder 10 may be derived from the information bit-stream 82 instead of the output of spectral analysis 52. Such configuration is illustrated in Fig 4, with adaptive pre-emphasis 56, limitation circuit 54 and A-D converter 72 rearranged as shown. A local D-A converter 100 converts the digital step-size information from bit-stream 82 into an analog emphasis control signal. The circuit arrangement of Fig 4 is particularly advantageous where the A-D converter 72 uses delta-sigma modulation so that the local D-A converter 100 is already contained within the A-D converter and no extra local D-A converter will be necessary. Similarly the step-size information supplied to adaptive delta-modulator circuit 22 may be derived from the step-size information bit-stream 28. This is again advantageous if A-D converter 26 uses delta-sigma modulation.

Instead of using a bandwidth limiting circuit 46 for limiting the bandwidth of step-size control signal applied to the adaptive delta-demodulator, D-A converter 44 may contain the bandwidth limitation. Similarly, bandwidth limitation circuit 80 may be eliminated if D-A converter 76 is similarly bandwidth limited.

Since it is desirable that the effect of a bit error should be a gain error of similar logarithmic magnitude for both large and small step-sizes, it is preferable to design the A-D converter 26 and D-A converter 44 so that the digital bit-stream 28 conveys the logarithm of the step-size. Similarly, the spectral information bit-stream preferably conveys the logarithm of the spectral information. In embodiments in which logarithmic and exponential circuits are inconvenient, it may be more practical to convey some other non-linear function of the step-size, such as the square root or the cube-root; such functions will not give perfectly uniform gain errors over the dynamic range of the system, but the extent of the variation will be much less than that resulting from a linear function.

For the same reasons discussed above for transmission of audio information, it is desirable to design an encoder-decoder system which conveys step-size information and spectral information at low bit rates of transmission and which can be implemented at low cost. In choosing the scheme for A-D and D-A conversion for converters 26, 44, 72 and 76 it is desirable to choose one that allows a low bit rate for the transmission of step-size information. Preferably, such bit rate is small compared to the bit rate for transmission of audio data. The A-D or D-A conversion performed in converters 26, 72 and 44, 76 can be one of many schemes, including PCM, delta modulation or delta-sigma modulation. While a PCM system requires a low bit rate, expensive converters must be used so that it is undesirable to use PCM in the converters. Delta-sigma modulation requires a somewhat higher bit rate (on the order of 5 to 10 kbit/sec) than PCM but it can be implemented simply and at low cost. Furthermore, the bit rate required for delta-sigma modulation is still low compared with the bit rate for the transmission of audio data (on the order of 200 to 300 kbit/sec). Therefore, delta-sigma modulation is used in the preferred embodiment discussed below. A description of delta-sigma modulation can be found in Delta Modulation Systems, Pentech Press Limited, London, 1975 by Raymond Steele.

Fig. 5 is a block diagram for a decoder system illustrating the preferred embodiment of the invention; the characteristics of most of the circuit blocks are defined for the system in Fig. 5. The system is particularly suitable for consumer use. The adaptive delta demodulator or audio decoder 42 comprises a pulse height modulator 202 and a leaky integrator 204. Pulse height modulator 202 multiplies the step-size control signal Vss by +1 or -1 in accordance with the audio data bit stream, and supplies the result to the leaky integrator 204. The leak time constant may be approximately 0.5 milliseconds which corresponds to a cut-off frequency of approximately 300 Hz. The integrator integrates the resulting signal to produce an analog audio signal. At frequencies below the frequency corresponding to the leak time constant, the system is strictly not delta but delta-sigma modulation.

In reference to Fig. 2A, the adaptive delta modulator 22 also includes a leaky integrator (not shown) with a cut-off frequency which is about the same as the one in the decoder. The step-size derivation means 18 may be a slope detector which responds to the pre-processed input audio signal by deriving a control signal indicative of the slopes of the signal components of the audio input with frequencies above the cut-off frequency and the amplitudes of the signal components with frequencies below the cut-off frequency.

In the preferred embodiment, the step-size or slope data are transmitted by delta-sigma modulation and in the form of the logarithm of the required step-size or slope. The slope data are therefore decoded in the slope decoder 205 by passage through a low pass filter 206 (corresponding to D-A converter 44 and bandwidth limitation 46 of Fig. 2B), which determines the bandwidth (and hence the rise-time) and ripple of the slope voltage. In the preferred embodiment, a 3-pole low pass filter is employed which causes the step-size control signal Vss to have a rise time of about 10 milliseconds corresponding to a bandwidth of about 50 Hz. The slope voltage is then applied to an exponentiator 208 or anti-log. circuit, which may be, for example, a bipolar transistor. If the normalized mean level of the bit stream (or the duty-cycle measured over the rise-time of the low pass filter) is written as y, then

Vss = Vo exp ky    where Vo and k are constants suitable for the particular implementation

If a practical value of k is 10 ln 2, this definition gives an increase of 6 dB in step-size for every increase of 0.1 in y. Since y is confined to a range of 0 to 1, the resultant maximum possible range of Vss is 60 dB.

The transmission of slope information in logarithm form reduces the dynamic range conveyed in the slope data bit-stream from about 50 dB to about 19 dB, and spreads the effect of bit errors more uniformly across the dynamic range. Since Vss is confined by the low pass filter 206 to a bandwidth of about 50 Hz, bit errors lead to slow random amplitude modulation of the output audio. The audible disturbance produced by errors in the slope data bit-stream may be negligible. It has been observed that uncorrected bit error rates of up to 1 in 100 or so produce nearly imperceptible disturbance of music or speech.

The low pass filter thus converts the digital slope data into analog data and limits its bandwidth. Low pass filter 206 therefore performs both the functions of both the D-A converter 44 and bandwidth limitation 46 of Fig. 2B. In reference to Figs. 2A, 2B and 5, delay means 20 introduces such delay that the slope data are received by filter 206 before the corresponding audio data are received by the pulse height modulator 202. Such time difference compensates for the rise time of about 10 milliseconds of Vss. In such manner, the need for a delay circuit in the decodor is eliminated.

Fig. 3B illustrates a set of de-emphasis curves which are complementary to those of the pre-emphasis curves of Fig. 3A. There are many ways to synthesize responses of this nature. The sliding band de-emphasis 78 defined in Fig. 5 shows one practical implementation of the de-emphasis characteristic. The system definitions for all the circuit blocks in Fig. 5 together with one set of values of the constants giving satisfactory results are listed below:

leaky integrator 204

$$\frac{1}{1 + sT_o}$$

3-pole L.P. filter 206,214

$$\left(\frac{1}{1 + sT_4}\right)^3$$

exponentiator 208 (slope decoder)

$$V_o \exp ky$$

exponentiator 216 (spectrum data)

$$f_o \exp kx$$

sliding band de-emphasis 78

$$\left[\frac{10sT_1}{1+sT_1} + \frac{1+sT_2}{1+sT_3}\right]^{-1}$$

fixed de-emphasis 118

$$\frac{1}{1+sT_5}$$

s        is the complex frequency

$T_o$        = 0.5 milliseconds

$T_1$        is variable so that the variable frequency of the sliding band de-emphasis $f_1$ is given by:

$$f_1 = 1/(2\pi T_1) = f_0 \exp kx$$

| | |
|---|---|
| $T_2$ | = 5 microseconds |
| $T_3$ | = 50 microseconds |
| $T_4$ | = 2 milliseconds |
| $T_5$ | = 25 microseconds |
| $f_o$ | = 4 kHz |
| $V_o$ | is scaling factor to suit the design of the audio decoder. |
| x and y | are the normalized mean levels of their respective bit-streams, i.e. the proportion of 1's measured over the smoothing time of the 3-pole L.P. filter. |
| k | = 10 ln 2 = 6.93 |

The spectrum decoder 212 comprising 3-pole filter 214 and exponentiator 216 is substantially the same as the slope decoder. It finds the normalized mean level x of the spectrum data input which conveys the logarithm of the variable frequency of the desired sliding band de-emphasis $f_1$ defined above, $f_1$ being different from the variable frequencies 86a-96a, 86a'-96a' of Figs. 3A, 3B. The spectrum decoder generates the exponent or anti-log. of the mean level and applies the resulting voltage or current to the sliding band de-emphasis 78. The emphasis control signal is even less affected by bit errors in transmission than the slope data control signal.

In delta modulation systems the sampling frequency is vastly greater than the minimum required by information theory. Non-audio spectral components in the output are at frequencies well above the audio band and only an elementary low pass filter such as filter 118 is necessary.

Fig. 6 is a schematic circuit diagram showing a possible implementation of the system of Fig. 5. As shown in Fig. 6, the sliding band de-emphasis circuit 78 employs a main path 78a with fixed characteristics in parallel with a further path 78b with variable characteristics. The variable characteristics of the further path are controlled by the resistance of a variable resistance 252, which in turn is controlled by the emphasis control signal from spectrum decoder 212. There is no systematic compression or expansion of the dynamic range; the further path is controlled ultimately by the spectrum of the input audio.

In reference to Fig. 2B, by limiting the bandwidths of the step-size and emphasis control signals, the characteristics of the delta demodulator 42 and de-emphasis 78 can only change slowly. Because they have slowly changing characteristics, the delta demodulator and de-emphasis are thereby rendered linear or quasi-linear. It makes little difference whether the demodulation is performed ahead of the de-emphasis or vice versa. This linear or quasi-linear feature of the decoder system is even clearer in the case of the preferred embodiment in Fig. 5. Four processes are performed on the audio bit stream: pulse height modulation, leaky integration, sliding band de-emphasis and fixed de-emphasis. All four are linear or quasi-linear processes so that they can be performed in any order.

In Fig. 5, the pulse height modulator 202 can be a relatively simple circuit since it is required only to switch the sign of voltage Vss depending on the state of the audio bit-stream. Thus the modulator 202 may be made at low cost for consumer decoders. However, multiplying the audio data by the step-size control signal at a different point , say after sliding band de-emphasis but before fixed de-emphasis, may have the advantage that quality of the audio output is improved. This may be desirable for applications such as in broadcast stations and other professional equipment. While the multiplication will have to be performed by a circuit more complex and therefore costlier than the type of pulse height modulator adequate for the arrangement of Fig. 5, the improvement in quality for professional applications may be well worth the additional cost. Multiplying the audio data at a different point is permissible because the four processes are effectively linear as explained above. All such possible arrangements of the four processes are within the scope of this invention.

Instead of using a single 3-pole filter in the slope and spectrum decoders 205, 212, it is possible to use a two pole filter instead if an additional single pole filter is used to filter the output of exponentiators 208, 216. Thus the filtering can be split into two steps: one before the exponentiation and the other one after. Any arrangement of filters may be used as long as the filter for filtering the slope or spectrum data before the exponentiation restricts the ripple in the filter output to a few percent of its mean value.

This invention together with the invention of the companion application referenced above reduce the transmission bit rate of the audio bit-stream to that comparable with or somewhat less than the bit rate required for a companded PCM system with comparable performance. The transmission bit rates for the encoder-decoder system of this invention may be in the region of 200 or 300 kbit per second. The transmission of spectral and step-size information may require about 10 or 23 kbit per second and does not add significantly to the total transmission bit rate required for the encoder-decoder system of this invention.

EP 0 138 547 B1

The encoder-decoder system of Figs. 2A and 2B, however, retains the advantages of delta modulation systems. The invention reduces and in many applications eliminates disturbing effects of bit errors. It and its components have high tolerance of errors. The receiving equipment (decoder) is inexpensive. The system is efficient in usage of channel capacity so that more excess capacity will exist for flexibility to add additional channels or more bandwidth will be available to other signals such as video signals. The transmission equipment (encoder) does not require special attention or require the use of non-complementary signal processing.

It will be apparent to those skilled in the art that the principles described herein are applicable not only to adaptive delta-modulation, but to other adaptive A-D and D-A coding systems, such as delta-sigma modulation, double integration delta-modulation, and PCM systems with variable reference voltages.

**Claims**

1. A spectral emphasis circuit comprising a spectral analysis circuit (52) providing a control signal indicative of the predominant frequency region of an input information signal, and an adaptive circuit (56) controlled by the control signal to impose a variable emphasis characteristic on the input information signal, characterized in that the control signal is bandwidth limited so as to change slowly relative to the input signal, and by a first delay circuit (58) delaying the input signal to the adaptive circuit (56) to compensate for the slow response of the control signal.

2. A spectral emphasis circuit according to claim 1, characterized in that the bandwidth limitation of the control signal is imposed in the spectral analysis circuit (52).

3. A spectral emphasis circuit according to claim 1, comprising means (22) for transmitting the information signal subjected to emphasis, characterized by means (72) for also transmitting the control signal, and in that the information signal is transmitted with a delay relative to the control signal corresponding to the delay provided by the first delay circuit (58).

4. A spectral emphasis circuit according to claim 3, characterized in that the means for transmitting the information signal comprises an analog to digital converter system (18, 20, 22, 24).

5. A spectral emphasis circuit according to claim 4, characterized in that the analog to digital converter system (18, 20, 22, 24) introduces an additional delay to the information signal, and further characterized by an additional delay circuit (74) delaying the transmitted control signal by an amount corresponding to the delay provided by the analog to digital converter system.

6. A spectral emphasis circuit according to claim 5, characterized in that the means (72) for transmitting the control signal comprises an analog to digital converter and the additional delay circuit (74) is a digital delay.

7. A spectral de-emphasis circuit for use with an emphasis circuit according to claim 3, 4, 5 or 6 and receiving the transmitted information signal and the control signal from the emphasis circuit, characterized by an adaptive circuit (78) imposing on the received information signal a variable de-emphasis characteristic complementary to the variable emphasis characteristic imposed in the emphasis circuit, the adaptive circuit (78) being controlled by the received control signal.

8. A spectral de-emphasis circuit according to claim 7, characterized in that the received control signal is bandwidth limited in the de-emphasis circuit to reduce the effects of errors introduced by the transmission, said bandwidth limitation introducing a delay which is compensated by the delay of the received information signal relative to the received control signal.

9. A spectral de-emphasis circuit receiving an information signal and a control signal from an emphasis circuit through a medium, wherein the reception of the information signal is delayed relative to the reception of the control signal, characterized by an adaptive circuit (78) imposing on the received information signal a variable de-emphasis characteristic, the adaptive circuit (78) being controlled by the received control signal, and in that the received control signal is bandwidth limited in the de-emphasis circuit to reduce the effects of errors introduced by the medium, said bandwidth limitation introducing a delay which is compensated by the delay of the received information signal relative to the

11

received control signal.

**10.** A spectral de-emphasis circuit according to claim 9, characterized in that the received control signal is bandwidth limited by a low-pass filter (80, 214) in the de-emphasis circuit.

**11.** A spectral de-emphasis circuit according to claim 9 or 10, characterized in that the filter (214) also acts as a delta-sigma demodulator (76) for demodulating the received control signal.

**12.** A spectral de-emphasis circuit according to claim 10 or 11, characterized in that the low-pass filter (80, 214) comprises three single pole filters, each with a time constant of about 2 ms.

**13.** A spectral de-emphasis circuit according to claim 11, further characterized by an exponentiator (216) for exponentiating a control signal transmitted in logarithm form.

**14.** A spectral de-emphasis circuit according to claims 12 and 13, characterized in that two single pole filters precede and one single pole filter follows the exponentiator.

**15.** A spectral de-emphasis circuit according to claim 13, characterized in that the ripple at the input to the exponentiator is limited to a few percent of the mean level.

**16.** A spectral emphasis or de-emphasis circuit according to claim 1, 8 or 9, characterized in that the delay introduced by the bandwidth limitation is approximately in the range 5 to 20 milliseconds.

**17.** A complementary emphasis/de-emphasis method wherein an information signal is subjected to adaptive modification of its spectral composition prior to transmission in response to a derived control signal, and wherein the received information signal is subjected to complementary adaptive modification of its spectral composition, characterized in that the control signal is transmitted in conjunction with the information signal for controlling the complementary adaptive modification of its spectral composition, in that the received control signal is bandwidth limited to reduce errors introduced by the transmission, and in that the transmitted information signal is delayed relative to the transmitted control signal to compensate for delay introduced by bandwidth limitation of the received control signal.

**18.** A spectral emphasis circuit comprising a spectral analysis circuit (52) providing a control signal indicative of the regions in a frequency spectrum, if any, where the predominant components of an input information signal are concentrated, and an adaptive circuit (56) controlled by the control signal to impose a variable emphasis characteristic on the input information signal, characterized in that the adaptive circuit is so constructed that when the predominant signal components are concentrated in a first frequency range, the variable characteristic consists of a sliding high-frequency boost with its corner frequency sliding upwards in response to the control signal to stay above the frequencies of the predominant signal components leaving the predominant signal components substantially unchanged, whereas when the predominant signal components are concentrated in a second frequency range with frequencies above those of the first frequency range, the variable characteristic of the emphasis consists of sliding high-frequency boost with its corner frequency above those of the predominant signal components but a cut at the frequencies of the predominant signal components themselves.

**19.** A spectral emphasis circuit according to claim 18, characterized in that the adaptive circuit is so constructed that when the predominant signal components are detected to be concentrated below a first predetermined frequency in the first frequency range, signal components above the first predetermined frequency are boosted, when the predominant signal components are detected to be concentrated below a second predetermined frequency but above the first predetermined frequency, signal components with frequencies above those of the predominant signal components are boosted, said second predetermined frequency being substantially at the lower end of the second frequency range, and when the predominant signal components are detected to be concentrated above the second predetermined frequency, signal components with frequencies above those of the predominant signal components are boosted, and the predominant signal components are cut.

**20.** A spectral de-emphasis circuit receiving an input information signal and a control signal indicative of the regions in a frequency spectrum, if any, where the predominant components of the input information signal are concentrated, characterized by an adaptive circuit (78) controlled by the control signal to impose a variable de-emphasis characteristic on the input information signal, and so constructed that when the predominant signal components are concentrated in a first frequency range, the variable de-emphasis characteristic consists of a sliding high-frequency cut with its corner frequency sliding upwards in response to the control signal to stay above the frequencies of the predominant signal components leaving the predominant signal components substantially unchanged, whereas when the predominant signal components are concentrated in a second frequency range with frequencies above those of the first frequency range, the variable de-emphasis characteristic consists of sliding high-frequency cut with its corner frequency above those of the predominant signal components but a boost at the frequencies of the predominant signal components themselves.

21. A spectral de-emphasis circuit according to claim 20, characterized in that the adaptive circuit is so constructed that when the predominant signal components are detected to be concentrated below a first predetermined frequency in the first frequency range, signal components above the first predetermined frequency are cut, when the predominant signal components are detected to be concentrated below a second predetermined frequency but above the first predetermined frequency, signal components with frequencies above those of the predominant signal components are cut, said second predetermined frequency being substantially at the lower end of the second frequency range, and when the predominant signal components are detected to be concentrated above the second predetermined frequency, signal components with frequencies above those of the predominant signal components are cut, and the predominant signal components are boosted.

22. A spectral emphasis or de-emphasis circuit according to claim 18, 19, 20 or 21, characterized in that the adaptive circuit is so constructed that when the predominant signal components are detected to be concentrated below the first predetermined frequency, the signal components below the first predetermined frequency remain substantially unchanged, and when the predetermined signal components are detected to be concentrated below the second predetermined frequency but above the first predetermined frequency, the predominant signal components and signal components with frequencies below those of the predominant signal components remain substantially unchanged.

23. A spectral emphasis or de-emphasis circuit according to claim 18, 19, 20 or 21, characterized in that the spectral components of the input signal with frequencies below those of the predominant signal components are left substantially unchanged.

24. A spectral emphasis or de-emphasis circuit according to claim 18, 19, 20 or 21, characterized in that the sliding corner frequency has a predetermined minimum value regardless of how low is the predominant frequency region of the input signal.

25. A spectral emphasis or de-emphasis circuit according to claim 24, characterized in that the minimum corner frequency is about 500 Hz.

26. A spectral emphasis or de-emphasis circuit according to claim 24, characterized in that the minimum corner frequency is about 1000 Hz.

27. A spectral emphasis or de-emphasis circuit according to any of claims 18 to 26, characterized in that the second predetermined frequency is about 2kHz.

28. A spectral emphasis or de-emphasis circuit according to any of claims 18 to 27, characterized in that when the predominant frequency region of the input signal is in the second frequency range, the emphasis (de-emphasis) characteristic remains a high frequency region of boost (cut) above the predominant frequency region of the input signal, and the components of the input signal in the predominant frequency region are subjected to a cut (boost).

29. A spectral emphasis or de-emphasis circuit according to any of claims 18 to 28, characterized in that the control signal is bandwidth limited so as to change slowly relative to the information signal.

30. A spectral emphasis circuit according to claim 29, further characterized by a delay circuit (58) delaying the input signal to the adaptive circuit (56) to compensate for the slow response of the control signal.

**31.** A spectral de-emphasis circuit according to claim 20, characterized in that the de-emphasis control signal indicates the normalized mean level x of the spectral information and wherein the de-emphasis applied is defined by the relationship:

$$\text{gain} = \left[ \frac{10sT_1}{1 + sT_1} + \frac{1 + sT_2}{1 + sT_3} \right]^{-1}$$

where

|       |                                      |
|-------|--------------------------------------|
| $s$   | is the complex frequency             |
| $T_1$ | $= f_o/(2\pi \exp kx)$                |
| $T_2$ | is about 5 microseconds              |
| $T_3$ | is about 50 microseconds             |
| $k$   | is a constant of predetermined value, and |
| $f_o$ | is about 4 kHz.                      |

**32.** A spectral de-emphasis circuit according to claim 31, wherein k is about 6.93.

**33.** A spectral emphasis circuit according to any of claims 18, 19, and 22 to 32, provided with an analogue to digital converter (18, 20, 22, 24) which introduces quantizing noise which increases with signal level coupled to the output of the spectral emphasis circuit.

**34.** A spectral de-emphasis circuit according to any of claims 20 to 32, provided with a digital to analog converter (42, 44, 46) which introduces quantising noise which increases with signal level coupled to the input of the spectral de-emphasis circuit.

**35.** A method of providing spectral emphasis to an information signal, preferably an audio signal, comprising making a spectral analysis of the input signal to provide a control signal indicative of the regions in a frequency spectrum, if any, where the predominant components of an input information signal are concentrated, and under the control of the control signal adaptively imposing a variable emphasis characteristic on the input information signal, characterized in that when the predominant signal components are concentrated in a first frequency range, the variable characteristic consists of a sliding high-frequency boost with its corner frequency sliding upwards in response to the control signal to stay above the frequencies of the predominant signal components leaving the predominant signal components substantially unchanged, whereas when the predominant signal components are concentrated in a second frequency range with frequencies above those of the first frequency range, the variable characteristic of the emphasis consists of sliding high-frequency boost with its corner frequency above those of the predominant signal components but a cut at the frequencies of the predominant signal components themselves.

**36.** A method of providing spectral de-emphasis to a received input information signal, preferably an audio signal, including the steps of receiving the input information signal and a control signal indicative of the regions in a frequency spectrum, if any, where the predominant components of the input information signal are concentrated, characterized by under the control of the control signal adaptively imposing a variable de-emphasis characteristic on the input information signal, so that when the predominant signal components are concentrated in a first frequency range, the variable de-emphasis characteristic consists of a sliding high-frequency cut with its corner frequency sliding upwards in response to the control signal to stay above the frequencies of the predominant signal components leaving the predominant signal components substantially unchanged, whereas when the predominant signal components are concentrated in a second frequency range with frequencies above those of the first frequency range, the variable de-emphasis characteristic consists of sliding high-frequency cut with its corner frequency above those of the predominant signal components but a boost at the frequencies of the predominant signal components themselves.

**Revendications**

14

1. Circuit d'accentuation spectrale comprenant un circuit d'analyse spectrale (52) qui fournit un signal de contrôle indiquant la région des fréquences prédominantes d'un signal d'information en entrée, et un circuit adaptatif (56) commandé par le signal de contrôle et qui applique au signal d'information en entrée une caractéristique d'accentuation variable, dont la particularité est que le signal de contrôle est à bande limitée de sorte qu'il ne change que relativement lentement par rapport au signal en entrée, et par un premier circuit de retard (58) retardant l'arrivée au circuit adaptatif (56) du signal en entrée pour compenser le temps de réponse du signal de contrôle.

2. Circuit d'accentuation spectrale selon la revendication 1, caractérisé par le fait que la limitation de la largeur de bande du signal de contrôle est appliquée au circuit d'analyse spectrale (52).

3. Circuit d'accentuation spectrale selon la revendication 1, comportant des moyens (22) de transmission du signal d'information qui est soumis à l'accentuation, caractérisé par des moyens (72) servant aussi à transmettre le signal de contrôle, et par le fait que le signal d'information est transmis avec un retard par rapport au signal de contrôle correspondant au retard provoqué par le premier circuit de retard (58).

4. Circuit d'accentuation spectrale selon la revendication 1, caractérisé par le fait que les moyens de transmission du signal d'information comportent un système de conversion analogique / digital (18, 20, 22, 24).

5. Circuit d'accentuation spectrale selon la revendication 1, caractérisé par le fait que le système de conversion analogique / digital (18, 20, 22, 24) introduit un retard supplémentaire au signal d'information et caractérisé en outre par un circuit de retard supplémentaire (74), retardant la transmission du signal de contrôle d'une valeur correspondant au retard provoqué par le système de conversion analogique / digital.

6. Circuit d'accentuation spectrale selon la revendication 5, caractérisé par le fait que les moyens (72) servant à transmettre le signal de contrôle comprennent un convertisseur analogique / digital et que le circuit de retard additionnel (74) est un relais digital.

7. Circuit de désaccentuation spectrale destiné à l'utilisation avec un circuit d'accentuation spectrale selon les revendications 3, 4, 5 ou 6 et qui reçoit le signal d'information et le signal de contrôle transmis par le circuit d'accentuation spectrale, caractérisé par un circuit adaptatif (78) qui applique au signal d'information reçu une caractéristique de désaccentuation complémentaire de la caractéristique d'accentuation appliquée dans le circuit d'accentuation spectrale, le circuit adaptatif (78) étant contrôlé par le signal de contrôle reçu.

8. Circuit de désaccentuation spectrale selon la revendication 7 caractérisé par le fait que le signal de contrôle reçu est limité en largeur de bande dans le circuit de désaccentuation spectrale afin de réduire les effets des erreurs introduites par la transmission, la dite limitation de largeur de bande introduisant un retard qui est compensé par le retard du signal d'information reçu par rapport au signal de contrôle reçu.

9. Circuit de désaccentuation spectrale du type recevant un signal d'information et un signal de contrôle d'un circuit d'accentuation par un intermédiaire dans lequel la réception du signal d'information est retardée par rapport à la réception du signal de contrôle, et caractérisé par un circuit adaptatif (78) appliquant au signal d'information reçu une caractéristique de désaccentuation variable, le circuit adaptatif (78) étant contrôlé par le signal de contrôle reçu, et par le fait que le signal de contrôle reçu est limité en largeur de bande dans le circuit de désaccentuation spectrale afin de réduire les effets des erreurs introduites par l'intermédiaire, la dite limitation de largeur de bande introduisant un retard qui est compensé par le retard du signal d'information reçu par rapport au signal de contrôle reçu.

10. Circuit de désaccentuation spectrale selon la revendication 9 caractérisé par le fait que le signal de contrôle reçu est limité en largeur de bande par un filtre passe-bas (80, 214) dans le circuit de désaccentuation spectrale.

11. Circuit de désaccentuation spectrale selon les revendications 9 ou 10, caractérisé par le fait que le filtre (214) agit aussi comme un démodulateur delta-sigma (76) pour la démodulation du signal de contrôle reçu.

12. Circuit de désaccentuation spectrale selon les revendications 10 ou 11, caractérisé par le fait que le filtre passe-bas (80, 214) comprend trois filtres à pôle unique, chacun avec une constante de temps d'environ 2 ms.

13. Circuit de désaccentuation spectrale selon la revendication 11, caractérisé en outre par un exponentiateur (216) qui exponentialise un signal de contrôle transmis sous forme logarithmique.

14. Circuit de désaccentuation spectrale selon les revendications 12 et 13, caractérisé par le fait que deux filtres à pôle unique précèdent, et un filtre à pôle unique suit l'exponentiateur.

15. Circuit de désaccentuation spectrale selon la revendication 13, caractérisé par le fait que le ronflement à l'entrée de l'exponentiateur est limité à quelques pour cent du niveau moyen.

16. Circuit d'accentuation et de désaccentuation spectrale selon les revendications 1, 8 ou 9, caractérisé par le fait que le retard introduit par la limitation de largeur de bande est approximativement dans la gamme de 5 à 20 millisecondes.

17. Procédé complémentaire d'accentuation et de désaccentuation dans laquelle le signal d'information est soumis à une modification adaptative de sa composition spectrale avant d'être transmis en réponse à un signal de contrôle dérivé, et dans laquelle le signal d'information reçu est soumis à une modification adaptative de sa composition spectrale, caractérisé par le fait que le signal de contrôle est transmis en conjonction avec le signal d'information pour contrôler la modification adaptative de sa composition spectrale, que le signal de contrôle reçu est limité en largeur de bande afin de réduire les effets des erreurs introduites par la transmission, et que le signal d'information est retardé par rapport au signal de contrôle transmis pour compenser le retard introduit par la limitation de largeur de bande du signal de contrôle transmis.

18. Circuit d'accentuation spectrale comprenant un circuit d'analyse spectrale (52) qui fournit un signal de contrôle indiquant, s'il en existe, les régions où les composantes prédominantes d'un signal d'information en entrée sont concentrées, et un circuit adaptatif (56) commandé par le signal de contrôle et qui applique au signal d'information en entrée une caractéristique d'accentuation variable, caractérisé en ce que le circuit adaptatif est construit de telle sorte que, lorsque les composantes prédominantes du signal sont concentrées dans une première plage de fréquences, la caractéristique variable consiste en une intensification à haute fréquence mobile et dont la fréquence limite se déplace vers le haut en réponse au signal de contrôle et reste au-dessus des fréquences des composantes prédominantes du signal, laissant les composantes prédominantes du signal presque inchangées, alors que, lorsque les composantes prédominantes du signal sont concentrées dans une seconde plage de fréquences située au-dessus de celles de la première plage de fréquences, la caractéristique variable d'accentuation consiste en une intensification à haute fréquence mobile et dont la fréquence limite est au-dessus des composantes prédominantes du signal, mais avec une coupure aux fréquences des composantes prédominantes du signal elles-mêmes.

19. Circuit d'accentuation spectrale selon la revendication 18, caractérisé en ce que le circuit adaptatif (56) est construit de telle sorte que, lorsque les composantes prédominantes du signal sont détectées comme étant concentrées en-dessous d'une première fréquence prédéterminée dans la première plage de fréquences, les composantes prédominantes du signal, les composantes du signal situées au-dessus de cette première fréquence prédéterminée sont accentuées, lorsque les composantes prédominantes du signal sont détectées comme étant concentrées en-dessous d'une seconde fréquence prédéterminée, mais au-dessus de la première fréquence prédéterminée, les composantes du signal dont les fréquences sont au-dessins des fréquences des composantes prédominantes du signal sont accentuées, la dite seconde fréquence prédéterminée se situant principalement à l'extrémité inférieure de la seconde plage de fréquences, et que, lorsque les composantes prédominantes du signal sont détectées comme étant situées au-dessus de la seconde fréquence prédéterminée, les composantes du signal dont les fréquences sont au-dessus des fréquences des composantes prédominantes du signal sont accentuées, et les composantes prédominantes du signal sont coupées.

**20.** Circuit de désaccentuation spectrale recevant en entrée un signal d'information et un signal de contrôle indiquant les régions d'un spectre de fréquences, s'il y en a, dans lequel les composantes prédominantes du signal d'information en entrée sont concentrées, caractérisé par un circuit adaptatif (78) commandé par le signal de contrôle et qui applique au signal d'information en entrée une caractéristique de désaccentuation variable et construit de telle sorte que, lorsque les composantes prédominantes du signal sont concentrées dans une première plage de fréquences, la caractéristique variable de désaccentuation consiste en une coupure à haute fréquence mobile et dont la fréquence limite se déplace vers le haut en réponse au signal de contrôle et reste au-dessus des fréquences des composantes prédominantes du signal, laissant les composantes prédominantes du signal presque inchangées, alors que, lorsque les composantes prédominantes du signal sont concentrées dans une seconde plage de fréquences située au-dessus de celles de la première plage de fréquences, la caractéristique variable de désaccentuation consiste en une coupure à haute fréquence mobile et dont la fréquence limite est au-dessus des composantes prédominantes du signal, mais avec une intensification aux fréquences des composantes prédominantes du signal elles-mêmes.

**21.** Circuit de désaccentuation spectrale selon la revendication 20, caractérisé par le fait que le circuit adaptatif est construit de telle sorte que, lorsque les composantes prédominantes du signal sont détectées comme étant concentrées en-dessous d'une première fréquence prédéterminée dans la première plage de fréquences, les composantes du signal situées au-dessus de cette première fréquence prédéterminée sont coupées, lorsque les composantes prédominantes du signal sont détectées comme étant concentrées en-dessous d'une seconde fréquence prédéterminée, mais au-dessus de la première fréquence prédéterminée, les composantes du signal dont les fréquences sont au-dessus des fréquences des composantes prédominantes du signal sont coupées, la dite seconde fréquence prédéterminée se situant principalement à l'extrémité inférieure de la seconde plage de fréquences, et que, lorsque les composantes prédominantes du signal sont détectées comme étant situées au-dessus de la seconde fréquence prédéterminée, les composantes du signal dont les fréquences sont au-dessus des fréquences des composantes prédominantes du signal sont coupées,et les composantes prédominantes du signal sont accentuées.

**22.** Circuit d'accentuation ou de désaccentuation spectrale selon la revendication 16, 19, 20 ou 21, caractérisé par le fait que le circuit adaptatif est construit de telle sorte que lorsque les composantes prédominantes du signal sont détectées comme étant concentrées en-dessous de la première fréquence prédéterminée, les composantes du signal situées en-dessous de la première plage de fréquences restent presque inchangées et que, lorsque les composantes prédominantes du signal sont détectées comme étant concentrées en-dessous de la seconde fréquence prédéterminée, mais au-dessus de la première fréquence prédéterminée, les composantes prédominantes du signal et les composantes du signal situées en-dessous de la première plage de fréquences restent presque inchangées.

**23.** Circuit d'accentuation ou de désaccentuation spectrale selon la revendication 18, 19, 20 ou 21, caractérisé par le fait que les composantes spectrales du signal en entrée dont les fréquences sont en-dessous de celles des composantes prédominantes du signal restent presque inchangées.

**24.** Circuit d'accentuation ou de désaccentuation spectrale selon la revendication 18, 19, 20 ou 21, caractérisé par le fait que la fréquence limite mobile a une valeur minimum prédéterminée, si basse que soit la région des fréquences prédominantes du signal d'entrée.

**25.** Circuit d'accentuation ou de désaccentuation spectrale selon la revendication 24, caractérisé par le fait que la fréquence limite a une valeur minimum de 500 Hz.

**26.** Circuit d'accentuation ou de désaccentuation spectrale selon la revendication 24, caractérisé par le fait que la fréquence limite a une valeur minimum de 1000 Hz.

**27.** Circuit d'accentuation ou de désaccentuation spectrale selon l'une ou l'autre des revendications 18 à 26, caractérisé par le fait que la seconde fréquence prédéterminée a une valeur d'environ 2 KHz.

**28.** Circuit d'accentuation ou de désaccentuation spectrale selon l'une ou l'autre des revendications 18 à 27, caractérisé par le fait que, quand la région des fréquences prédominantes du signal en entrée est dans la seconde plage de fréquences, la caractéristique d'accentuation ou de désaccentuation reste une région de hautes fréquences d'accentuation ou de coupure, située au-dessus de la région des composantes prédominantes du signal en entrée, et que les composantes du signal en entrée qui sont situées dans la région des fréquences prédominantes sont soumises à une coupure ou à une accentuation.

29. Circuit d'accentuation ou de désaccentuation spectrale selon l'une ou l'autre des revendications 18 à 28, caractérisé par le fait que le signal de contrôle est à bande limitée de sorte qu'il ne change que relativement lentement par rapport au signal d'information.

30. Circuit d'accentuation spectrale selon la revendication 29, caractérisé en outre par un circuit de retard (58) qui retarde l'arrivée au circuit adaptatif (56) du signal en entrée pour compenser le temps de réponse du signal de contrôle.

31. Un circuit de désaccentuation spectrale selon la revendication 20, caractérisé par le fait que le signal de contrôle de désaccentuation indique le niveau moyen normalisé x de l'information spectrale et dans lequel la désaccentuation appliquée est définie par la relation :

$$\text{gain} = \left[ \frac{10sT_1}{1 + sT_1} + \frac{1 + sT_2}{1 + sT_3} \right] - 1$$

où

s     est la fréquence complexe
$T_1$     $= f_o/(2\pi \exp kx)$
$T_2$     est d'environ 5 microsecondes
$T_3$     est d'environ 50 microsecondes
k     est une constante de valeur prédéterminée et
$f_o$     est d'environ 4 KHz

32. Circuit de désaccentuation spectrale selon la revendication 31, dans lequel k vaut environ 6,93.

33. Circuit d'accentuation spectrale selon l'une ou l'autre des revendications 18, 19 et de 22 à 32, équipé d'un convertisseur analogique / digital (18, 20, 22, 24), lequel introduit un bruit de discrétisation augmentant avec le niveau du signal et est couplé à la sortie du circuit d'accentuation spectrale.

34. Circuit de désaccentuation spectrale selon l'une ou l'autre des revendications 20 à 32, équipé d'un convertisseur analogique / digital (42, 44, 46), lequel introduit un bruit de discrétisation augmentant avec le niveau du signal et est couplé à l'entrée du circuit de désaccentuation spectrale.

35. Procédé de production d'une accentuation spectrale d'un signal d'information, de préférence un signal audio, ce qui comporte l'analyse spectrale du signal en entrée afin de produire un signal de contrôle indiquant les régions d'un spectre de fréquences, s'il y en a, dans lequel les composantes prédominantes du signal du signal d'information en entrée sont concentrées, et sous le contrôle d'un signal de contrôle appliquant de façon adaptative une caractéristique variable d'accentuation sur le signal d'information en entrée, caractérisé par le fait que, lorsque les composantes prédominantes du signal sont concentrées dans une première plage de fréquences, la caractéristique variable consiste en une intensification à haute fréquence mobile et dont la fréquence limite se déplace vers le haut en réponse au signal de contrôle et reste au-dessus des fréquences des composantes prédominantes du signal, laissant les composantes prédominantes du signal presque inchangées, alors que, lorsque les composantes prédominantes du signal sont concentrées dans une seconde plage de fréquences située au-dessus de celles de la première plage de fréquences, la caractéristique variable d'accentuation consiste en une intensification à haute fréquence mobile et dont la fréquence limite est au-dessus des composantes prédominantes du signal, mais avec une coupure aux fréquences des composantes prédominantes du signal elles-mêmes.

36. Procédé de production d'une désaccentuation spectrale d'un signal d'information reçu, de préférence un signal audio, ce qui comporte les étapes de réception d'un signal d'information en entrée et un signal de contrôle indiquant les régions d'un spectre de fréquences, s'il y en a, dans lequel les composantes prédominantes du signal d'information en entrée sont concentrées, et caractérisé par le fait que, sous le contrôle d'un signal de contrôle, on applique de façon adaptative une caractéristique variable de désaccentuation sur le signal d'information en entrée, de sorte que, lorsque les composantes prédominantes du signal sont concentrées dans une première plage de fréquences, la caractéristique variable de désaccentuation consiste en une coupure à haute fréquence mobile et dont la fréquence limite se déplace vers le haut en réponse au signal de contrôle et reste au-dessus des fréquences des composantes prédominantes du signal, laissant les composantes prédominantes du signal presque inchangées, alors que, lorsque les composantes prédominantes du signal sont concentrées dans une seconde plage de fréquences située au-dessus de celles de la première plage de fréquences, la caractéristique variable de désaccentuation consiste en une coupure à haute fréquence mobile et dont la fréquence limite est au-dessus des composantes prédominantes du signal, mais avec une intensification aux fréquences des composantes prédominantes du signal elles-mêmes.

**Patentansprüche**

1.  Spektralemphasisschaltung, umfassend eine Spektralanalyseschaltung (52), die ein Steuersignal liefert, das den vorherrschenden Frequenzbereich eines Eingangsinformationssignals angibt, und eine adaptive Schaltung (56), die von dem Steuersignal gesteuert wird, um dem Eingangsinformationssignal eine variable Emphasischarakteristik aufzuprägen, dadurch **gekennzeichnet,** daß das Steuersignal bandbreitenbegrenzt ist, so daß es sich in bezug auf das Eingangssignal langsam ändert, und daß eine erste Verzögerungsschaltung (58) vorgesehen ist, die das Eingangssignal zu der adaptiven Schaltung (56) verzögert, um die langsame Antwort des Steuersignals zu kompensieren.

2.  Spektralemphasisschaltung nach Anspruch 1, dadurch **gekennzeichnet,** daß die Bandbreitenbegrenzung des Steuersignals in der Spektralanalyseschaltung (52) ausgeübt wird.

3.  Spektralemphasisschaltung nach Anspruch 1, umfassend eine Einrichtung (22) zur Übertragung des der Emphasis unterzogenen Informationssignals,
    **gekennzeichnet,** durch eine Einrichtung (72) zur weiteren Übertragung des Steuersignals und dadurch, daß das Informationssignal mit einer Verzögerung relativ zu dem Steuersignal entsprechend der von der ersten Verzögerungsschaltung (58) bewirkten Verzögerung übertragen wird.

4.  Spektralemphasisschaltung nach Anspruch 3, dadurch **gekennzeichnet,** daß die Einrichtung zur Übertragung des Informationssignals ein Analog-Digital-Umsetzungssystem (18, 20, 22, 24) umfaßt.

5.  Spektralemphasisschaltung nach Anspruch 4, dadurch **gekennzeichnet,** daß das Analog-Digital-Umsetzungssystem (18, 20, 22, 24) das Informationssignal einer zusätzlichen Verzögerung unterzieht, und daß eine zusätzliche Verzögerungsschaltung (74) vorgesehen ist, die das übertragene Steuersignal um einen Betrag verzögert, der der von dem Analog-Digital-Umsetzungssystem bewirkten Verzögerung entspricht.

6.  Spektralemphasisschaltung nach Anspruch 5, dadurch **gekennzeichnet,** daß die Einrichtung (72) zur Übertragung des Steuersignals einen Analog-Digital-Umsetzer umfaßt und die zusätzliche Verzögerungsschaltung (74) eine digitale Verzögerung ist.

7.  Spektraldeemphasisschaltung zur Verwendung mit einer Emphasisschaltung nach Anspruch 3, 4, 5 oder 6, die das übertragene Informationssignal und das Steuersignal von der Emphasisschaltung empfängt, **gekennzeichnet** durch eine adaptive Schaltung (78), die dem empfangenen Informationssignal eine variable Deemphasischarakteristik aufprägt, die der variablen Emphasischarakteristik komplementär ist, welche in der Emphasisschaltung aufgeprägt wird, wobei die adaptive Schaltung (78) von dem empfangenen Steuersignal gesteuert wird.

8.  Spektraldeemphasisschaltung nach Anspruch 7, dadurch **gekennzeichnet,** daß das empfangene Steuersignal in der Deemphasisschaltung bandbreitenbegrenzt wird, um Auswirkungen von Fehlern zu vermindern, die durch die Übertragung eingeführt werden, wobei die Bandbreitenbegrenzung eine Verzögerung einführt, die durch die Verzögerung des empfangenen Informationssignals relativ zu dem empfangenen Steuersignal kompensiert wird.

**9.** Spektraldeemphasisschaltung, die über ein Medium ein Informationssignal und ein Steuersignal von einer Emphasisschaltung empfängt, wobei der Empfang des Informationssignals relativ zum Empfang des Steuersignals verzögert ist, **gekennzeichnet** durch eine adaptive Schaltung (78), die dem empfangenen Informationssignal eine variable Deemphasischarakteristik aufprägt, wobei die adaptive Schaltung (78) von dem empfangenen Steuersignal gesteuert wird und das empfangene Steuersignal in der Deemphasisschaltung bandbreitenbegrenzt wird, um Auswirkungen von durch das Medium eingeführten Fehlern zu vermindern, und wobei die Bandbreitenbegrenzung eine Verzögerung einführt, die durch die Verzögerung des empfangenen Informationssignals relativ zu dem empfangenen Steuersignal kompensiert wird.

**10.** Spektraldeemphasisschaltung nach Anspruch 9, dadurch **gekennzeichnet,** daß das empfangene Steuersignal mittels eines Tiefpaßfilters (80, 214) in der Deemphasisschaltung bandbreitenbegrenzt wird.

**11.** Spektraldeemphasisschaltung nach Anspruch 9 oder 10, dadurch **gekennzeichnet,** daß das Filter (214) außerdem als Deltasigmademodulator (76) zur Demodulation des empfangenen Steuersignals dient.

**12.** Spektraldeemphasisschaltung nach Anspruch 10 oder 11, dadurch **gekennzeichnet,** daß das Tiefpaßfilter (80, 214) drei einpolige Filter umfaßt, die je eine Zeitkonstante von etwa 2 ms aufweisen.

**13.** Spektraldeemphasisschaltung nach Anspruch 11, ferner **gekennzeichnet** durch einen Exponentiator (216) zur Potenzierung eines in logarithmischer Form übertragenen Steuersignals.

**14.** Spektraldeemphasisschaltung nach Anspruch 12 und 13, dadurch **gekennzeichnet,** daß zwei einpolige Filter dem Exponentiator vorgeschaltet und ein einpoliges Filter ihm nachgeschaltet sind.

**15.** Spektraldeemphasisschaltung nach Anspruch 13, dadurch **gekennzeichnet,** daß die Welligkeit am Eingang des Exponentiators auf einige wenige Prozent des mittleren Pegels begrenzt ist.

**16.** Spektralemphasis- oder -deemphasisschaltung nach Anspruch 1, 8 oder 9, dadurch **gekennzeichnet,** daß die von der Bandbreitenbegrenzung eingeführte Verzögerung annähernd im Bereich von 5 bis 20 ms ist.

**17.** Komplementäres Emphasis/Deemphasisverfahren, bei dem ein Informationssignal vor einer Übertragung nach Maßgabe eines abgeleiteten Steuersignals einer adaptiven Modifikation seiner spektralen Zusammensetzung unterzogen wird und bei dem das empfangene Informationssignal einer komplementären adaptiven Modifikation seiner spektralen Zusammensetzung unterzogen wird,
dadurch **gekennzeichnet,** daß das Steuersignal in Verbindung mit dem Informationssignal zur Steuerung der komplementären adaptiven Modifikation seiner spektralen Zusammensetzung übertragen wird, daß das empfangene Steuersignal zur Verminderung von durch die Übertragung eingeführten Fehlern bandbreitenbegrenzt wird und daß das übertragene Informationssignal relativ zu dem übertragenen Steuersignal verzögert wird, um eine durch die Bandbreitenbegrenzung des empfangenen Steuersignal eingeführte Verzögerung zu kompensieren.

**18.** Spektralemphasisschaltung, umfassend eine Spektralanalyseschaltung (52), die ein Steuersignal liefert, das die Bereiche in einem Frequenzspektrum, sofern vorhanden, angibt, wo die vorherrschenden Komponenten eines Eingangsinformationssignals konzentriert sind, und eine adaptive Schaltung (56), die von dem Steuersignal gesteuert wird, um dem Eingangsinformationssignal eine variable Emphasischarakteristik aufzuprägen,
dadurch **gekennzeichnet,** daß die adaptive Schaltung so aufgebaut ist, daß, wenn die vorherrschenden Signalkomponenten in einem ersten Frequenzbereich konzentriert sind, die variable Charakteristik aus einer gleitenden Hochfrequenzanhebung besteht, deren Eckfrequenz nach Maßgabe des Steuersignals aufwärts gleitet, um über den Frequenzen der vorherrschenden Signalkomponenten zu liegen und die vorherrschenden Signalkomponenten im wesentlichen unverändert zu lassen, während, wenn die vorherrschenden Signalkomponenten in einem zweiten Frequenzbereich konzentriert sind, dessen Frequenzen über denen des ersten Frequenzbereichs liegen, die variable Charakteristik der Emphasis aus einer gleitenden Hochfrequenzanhebung, deren Eckfrequenz über den Frequenzen der vorherrschenden Signalkomponenten liegt, aber aus einer Absenkung bei den Frequenzen der vorherrschen-

20

**EP 0 138 547 B1**

den Signalkomponenten selbst besteht.

**19.** Spektralemphasisschaltung nach Anspruch 18, dadurch **gekennzeichnet,** daß die adaptive Schaltung so aufgebaut ist, daß, wenn festgestellt wird, daß die vorherrschenden Signalkomponenten unterhalb einer ersten vorbestimmten Frequenz im ersten Frequenzbereich konzentriert sind, Signalkomponenten oberhalb der ersten vorbestimmten Frequenz angehoben werden, wenn festgestellt wird, daß die vorherrschenden Signalkomponenten unterhalb einer zweiten vorbestimmten Frequenz, aber oberhalb der ersten vorbestimmten Frequenz konzentriert sind, Signalkomponenten mit Frequenzen oberhalb denen der vorherrschenden Signalkomponenten angehoben werden, wobei die zweite vorbestimmte Frequenz im wesentlichen am unteren Ende des zweiten Frequenzbereichs liegt, und, wenn festgestellt wird, daß die vorherrschenden Signalkomponenten oberhalb der zweiten vorbestimmten Frequenz konzentriert sind, Signalkomponenten mit Frequenzen oberhalb jener der vorherrschenden Signalkomponenten angehoben und die vorherrschenden Signalkomponenten abgesenkt werden.

**20.** Spektraldeemphasisschaltung, die ein Eingangsinformationssignal und ein Steuersignal empfängt, die Bereiche in einem Frequenzspektrum, sofern vorhanden, angibt, wo die vorherrschenden Komponenten des Eingangsinformationssignals konzentriert sind, **gekennzeichnet** durch eine adaptive Schaltung (78), die von dem Steuersignal gesteuert wird, um dem Eingangsinformationssignal eine variable Deemphasischarakteristik aufzuprägen, und die so aufgebaut ist, daß, wenn die vorherrschenden Signalkomponenten in einem ersten Frequenzbereich konzentriert sind, die variable Deemphasischarakteristik aus einer gleitenden Hochfrequenzabsenkung besteht, deren Eckfrequenz nach Maßgabe des Steuersignals aufwärts gleitet, um oberhalb der Frequenzen der vorherrschenden Signalkomponenten zu liegen und die vorherrschenden Signalkomponenten im wesentlichen unverändert zu lassen, während, wenn die vorherrschenden Signalkomponenten in einem zweiten Frequenzbereich mit Frequenzen oberhalb derer des ersten Frequenzbereichs konzentriert sind, die variable Deemphasischarakteristik aus einer gleitenden Hochfrequenzabsenkung, deren Eckfrequenz oberhalb der Frequenzen der vorherrschenden Signalkomponenten liegt, und einer Anhebung bei Frequenzen der vorherrschenden Signalkomponenten selbst besteht.

**21.** Spektraldeemphasisschaltung nach Anspruch 20, dadurch **gekennzeichnet,** daß die adaptive Schaltung so aufgebaut ist, daß, wenn festgestellt wird, daß die vorherrschenden Signalkomponenten unterhalb einer ersten vorbestimmten Frequenz in dem ersten Frequenzbereich konzentriert sind, Signalkomponenten oberhalb der ersten vorbestimmten Frequenz abgesenkt werden, wenn festgestellt wird, daß die vorherrschenden Signalkomponenten unterhalb einer zweiten vorbestimmten Frequenz, aber oberhalb der ersten vorbestimmten Frequenz konzentriert sind, Signalkomponenten mit Frequenzen oberhalb jener der vorherrschenden Signalkomponenten abgesenkt werden, wobei die zweite vorbestimmt Frequenz im wesentlichen am unteren Ende des zweiten Frequenzbereichs liegt, und, wenn festgestellt wird, daß die vorherrschenden Signalkomponenten oberhalb der zweiten vorbestimmten Frequenz konzentriert sind, Signalkomponenten mit Frequenzen oberhalb jener der vorherrschenden Signalkomponenten abgesenkt werden und die vorherrschenden Signalkomponenten angehoben werden.

**22.** Spektralemphasis- oder -deemphasisschaltung nach Anspruch 18, 19, 20 oder 21, dadurch **gekennzeichnet,** daß die adaptive Schaltung so aufgebaut ist, daß, wenn festgestellt wird, daß die vorherrschenden Signalkomponenten unterhalb der ersten vorbestimmten Frequenz konzentriert sind, die Signalkomponenten unterhalb der ersten vorbestimmten Frequenz im wesentlichen unverändert bleiben, und, wenn festgestellt wird, daß die vorherrschenden Signalkomponenten unterhalb der zweiten vorbestimmten Frequenz, aber oberhalb der ersten vorbestimmten Frequenz konzentriert sind, die vorherrschenden Signalkomponenten und Signalkomponenten mit Frequenzen unterhalb jener der vorherrschenden Signalkomponenten im wesentlichen unverändert bleiben.

**23.** Spektralemphasis oder -deemphasisschaltung, nach Anspruch 18, 19, 20 oder 21, dadurch **gekennzeichnet,** daß die Spektralkomponenten des Eingangssignals mit Frequenzen unterhalb jener der vorherrschenden Signalkomponenten im wesentlichen unverändert gelassen werden.

**24.** Spektralemphasis- oder -deemphasisschaltung nach Anspruch 18, 19, 20 oder 21, dadurch **gekennzeichnet,** daß die gleitende Eckfrequenz einen vorbestimmten Minimalwert unabhängig davon hat, wie niedrig der vorherrschende Frequenzbereich des Eingangssignals ist.

21

25. Spektralemphasis- oder -deemphasisschaltung nach Anspruch 24, dadurch **gekennzeichnet,** daß die minimale Eckfrequenz etwa 500 Hz beträgt.

26. Spektralemphasis- oder -deemphasisschaltung nach Anspruch 24, dadurch **gekennzeichnet,** daß die minimale Eckfrequenz etwa 1000 Hz beträgt.

27. Spektralemphasis- oder -deemphasisschaltung nach einem der Ansprüche 18 bis 26, dadurch **gekennzeichnet,** daß die zweite vorbestimmte Frequenz etwa 2 kHz beträgt.

28. Spektralemphasis- oder -deemphasisschaltung nach einem der Ansprüche 18 bis 27, dadurch **gekennzeichnet,** daß, wenn der vorherrschende Frequenzbereich des Eingangssignals im zweiten Frequenzbereich liegt, die Emphasis-(Deemphasis)-Charakteristik ein Hochfrequenzbereich der Anhebung (Absenkung) oberhalb des vorherrschenden Frequenzbereichs des Eingangssignals bleibt und die Komponenten des Eingangssignals im vorherrschenden Frequenzbereich einer Absenkung (Anhebung) unterzogen werden.

29. Spektralemphasis- oder -deemphasisschaltung nach einem der Ansprüche 18 bis 28, dadurch **gekennzeichnet,** daß das Steuersignal bandbreitenbegrenzt wird, so daß es sich relativ zum Informationssignal langsam ändert.

30. Spektralemphasisschaltung nach Anspruch 29, ferner **gekennzeichnet** durch eine Verzögerungsschaltung (58), die das Eingangssignal zur adaptiven Schaltung (56) verzögert, um die langsame Antwort des Steuersignals zu kompensieren.

31. Spektraldeemphasisschaltung nach Anspruch 20, dadurch **gekennzeichnet,** daß das Deemphasissteuersignal den normierten mittleren Pegel x der Spektralinformation angibt, und daß die ausgeübte Deemphasis durch folgende Beziehung gegeben ist:

$$\text{Verstärkung} = \left[ \frac{10sT_1}{1 + sT_1} + \frac{1 + sT_2}{1 + sT_3} \right]^{-1}$$

wobei

$s$     die komplexe Frequenz ist,

$T_1$   = $f_0/(2\pi \exp kx)$

$T_2$   = etwa 5 $\mu$s beträgt

$T_3$   = etwa 50 $\mu$s beträgt

$k$     eine Konstante eines vorbestimmten Werts ist und

$f_0$    4 kHz beträgt.

32. Spektraldeemphasisschaltung nach Anspruch 31, dadurch **gekennzeichnet,** daß k etwa 6,93 beträgt.

33. Spektralemphasisschaltung nach einem der Ansprüche 18, 19 und 22 bis 32, die mit einem Analog-Digital-Umsetzer (18, 20, 22, 24) versehen ist, der Quantisierungsrauschen einführt, das mit dem Signalpegel zunimmt, und der mit dem Ausgang der Spektralemphasisschaltung gekoppelt ist.

34. Spektraldeemphasisschaltung nach einem der Ansprüche 20 bis 32, die mit einem Digital-Analog-Umsetzer (42, 44, 46) versehen ist, der Quantisierungsrauschen einführt, das mit dem Signalpegel zunimmt, und der mit dem Eingang der Spektraldeemphasisschaltung gekoppelt ist.

35. Verfahren zum Bewirken einer Spektralemphasis an einem Informationssignal, vorzugsweise einem Audiosignal, bei dem eine Spektralanalyse des Eingangssignals zur Schaffung eines Steuersignals gemacht wird, das die Bereiche in einem Frequenzspektrum, sofern vorhanden, angibt, wo die vorherrschenden Komponenten eines Eingangsinformationssignals konzentriert sind, und bei dem unter der Steuerung des Steuersignals dem Eingangsinformationssignal adaptiv eine variable Emphasischarakteristik aufgeprägt wird, dadurch **gekennzeichnet,** daß, wenn die vorherrschenden Signalkomponenten in einem ersten Frequenzbereich konzentriert sind, die variable Charakteristik aus einer gleitenden Hochfrequenzanhebung besteht, deren Eckfrequenz nach Maßgabe des Steuersignals aufwärts gleitet, um über den Frequenzen der vorherrschenden Signalkomponenten zu liegen und die vorherrschenden Signalkomponenten im wesentlichen unverändert zu lassen, während, wenn die vorherrschenden Signalkomponenten in einem zweiten Frequenzbereich mit Frequenzen oberhalb derer des ersten Frequenzbereichs konzentriert sind, die variable Charakteristik der Emphasis aus einer gleitenden Hochfrequenzanhebung, deren Eckfrequenz oberhalb der Frequenzen der vorherrschenden Signalkomponenten liegt, und einer Absenkung bei Frequenzen der vorherrschenden Signalkomponenten selbst besteht.

36. Verfahren zum Bewirken einer Spektraldeemphasis an einem empfangenen Eingangsinformationssignal, vorzugsweise einem Audiosignal, mit den Schritten des Empfangens des Eingangsinformationssignals und eines Steuersignals, das die Bereiche in einem Frequenzspektrum angibt, sofern vorhanden, wo die vorherrschenden Komponenten des Eingangsinformationssignals konzentriert sind,
dadurch **gekennzeichnet,** daß unter der Steuerung des Steuersignals dem Eingangsinformationssignal adaptiv eine variable Deemphasischarakteristik aufgeprägt wird, so daß, wenn die vorherrschenden Signalkomponenten in einem ersten Frequenzbereich konzentriert sind, die variable Deemphasischarakteristik aus einer gleitenden Hochfrequenzabsenkung besteht, deren Eckfrequenz nach Maßgabe des Steuersignals aufwärts gleitet, um oberhalb der Frequenzen der vorherrschenden Signalkomponenten zu liegen und die vorherrschenden Signalkomponenten im wesentlichen unverändert zu lassen, während, wenn die vorherrschenden Signalkomponenten in einem zweiten Frequenzbereich mit Frequenzen oberhalb derer des ersten Frequenzbereichs konzentriert sind, die variable Deemphasischarakteristik aus einer gleitenden Hochfrequenzabsenkung, deren Eckfrequenz oberhalb der Frequenzen der vorherrschenden Signalkomponenten liegt, und einer Anhebung bei Frequenzen der vorherrschenden Signalkomponenten selbst besteht.

**FIG._5.**

AUDIO DECODER — 42

pulse-height modulator — 202

leaky integrator — 204

$$\frac{1}{1+sT_0}$$

CONTROL OF STEP-SIZE

SLIDING-BAND DE-EMPHASIS — 78

$$\left[\frac{10sT_1}{1+sT_1} + \frac{1+sT_2}{1+sT_3}\right]^{-1}$$

CONTROL OF $f_1 = \frac{1}{2\pi T_1}$

FIXED DE-EMPHASIS — 118

$$\left[1+sT_5\right]^{-1}$$

AUDIO OUTPUT

SLOPE DECODER — 205

3-pole L.P. filter — 206

$$\left(\frac{1}{1+sT_4}\right)^3$$

exponentiator — 208

$$V_0 \, expky$$

SPECTRUM DECODER — 212

3-pole L.P. filter — 214

$$\left(\frac{1}{1+sT_4}\right)^3$$

exponentiator — 216

$$f_0 \, expkx$$

NOISE AND DISTORTION

STEP-SIZE

**FIG._I.**

EP 0 138 547 B1

FIG._2A.

EP 0 138 547 B1

POST-PROCESSING 96

CLOCK

AUDIO
BIT-STREAM 30 → ADAPTIVE DELTA-DEMODULATOR 42 → ADAPTIVE DE-EMPHASIS 78 → LOW-PASS FILTER 118 → AUDIO OUTPUT

BANDWIDTH LIMITATION 46

CLOCK

STEP-SIZE (DIGITAL) 28 → D-A CONVERTER 44

BANDWIDTH LIMITATION 80

SPECTRAL (DIGITAL) 82 → D-A CONVERTER 76

CLOCK

FIG._2B.

ADAPTIVE PRE-EMPHASIS 56

BANDWIDTH LIMITATION 54

LOCAL D-A CONVERTER 100

A-D CONVERTER 72

DIGITAL DELAY 74

SPECTRAL INFORMATION BIT-STREAM 82

FIG._4.

PRE-EMPHASIS CHARACTERISTICS

FIG._3A.

DE-EMPHASIS CHARACTERISTICS

FIG._3B.

FIG._6.

EP 0 138 547 B1